# EUROPEAN PATENT APPLICATION

(11) **EP 2 913 312 A1**
(43) Date of publication of application: **02.09.2015**
(21) Application number: 14000684.2
(22) Date of filing: 26.02.2014
(51) Int. Cl.: C03C 8/10, C04B 35/01, C04B 35/634, H01B 1/22, H01L 31/0224, H01L 31/042

(54) **Silver-lead-silicate glass for electroconductive paste composition**

(71) Applicant: Heraeus Precious Metals North America Conshohocken LLC, West Conshohocken, PA 19428 (US)
(72) Inventor: Raskar, Devidas Balu, Pune 411039 (IN); Song, Xiao Chao, Singapore 640961 (SG); Chen, Chi Long, Singapore 644656 (SG)
(74) Representative: Brand, Normen

(57) **Abstract**

An electroconductive paste composition including metallic particles, glass frit including lead oxide, silicon dioxide, and silver or a silver-containing compound, and an organic vehicle is provided. The invention also provides a solar cell produced by applying the electroconductive paste according to the invention to a silicon wafer and firing the silicon wafer. The invention further provides a solar cell module comprising electrically interconnected solar cells according to the invention. The invention also provides a method of producing a solar cell, including the steps of providing a silicon wafer having a front surface and a back surface, applying an electroconductive paste according to the invention to the silicon wafer, and firing the silicon wafer.

## Description

### Technical Field

The invention relates to electroconductive paste compositions. Specifically, the paste is utilized in solar cell technology, especially for forming front side electrodes. In one aspect, the electroconductive paste composition includes conductive metallic particles, an organic vehicle, and glass frit. The glass frit includes, among other components, silver or a silver-containing compound. Another aspect of the invention is a solar cell produced by applying the electroconductive paste of the invention to a silicon wafer. The invention also provides a solar panel comprising electrically interconnected solar cells. According to another aspect, the invention also provides a method of producing a solar cell.

### Background

Solar cells are devices that convert the energy of light into electricity using the photovoltaic effect. Solar power is an attractive green energy source because it is sustainable and produces only non-polluting by-products. In operation, when light hits a solar cell, a fraction of the incident light is reflected by the surface and the remainder is transmitted into the solar cell. The photons of the transmitted light are absorbed by the solar cell, which is usually made of a semiconducting material such as silicon. The energy from the absorbed photons excites electrons of the semiconducting material from their atoms, generating electron-hole pairs. These electron-hole pairs are then separated by p-n junctions and collected by conductive electrodes which are applied on the solar cell surface. In this way, electricity may be conducted between interconnected solar cells.

Solar cells typically have electroconductive pastes applied to both their front and back surfaces which, when fired, form electrodes. A typical electroconductive paste for forming front side electrodes contains metallic particles, glass frit, and an organic vehicle. These components are usually selected to take full advantage of the theoretical potential of the resulting solar cell. For example, it is desirable to maximize the contact between the electroconductive paste and silicon surface, and the metallic particles themselves, so that the charge carriers can flow through the silicon interface to the printed finger lines and bus bars on the front face of the solar cell. To provide for this contact, the glass particles in the composition etch through the antireflection coating layer upon firing and help to build contact between the conductive metal and the underlying silicon substrate. On the other hand, the glass must not be so aggressive that it shunts the p-n junction after firing. Thus, the goal is to minimize contact resistance while keeping the p-n junction intact so as to achieve improved efficiency. Known compositions have high contact resistance due to the insulating effect of the glass at the interface of the metallic layer and silicon wafer. Further, glass frit is known to have wide melting temperature ranges, making its behavior strongly dependent on processing parameters.

Accordingly, glass compositions for use in electroconductive pastes which improve electrical contact, as well as adhesion, between the paste and the underlying substrate are desired.

### Summary

Accordingly, the glass compositions of the invention, which include silver or a silver-containing compound, exhibit improved electrical contact. Additionally, the presence of the silver or a silver compound alters the glass transition temperature of the glass frit, such that the melting behavior of the glass frit and the resulting processing parameters may be adjusted according to varying specifications.

The invention provides an electroconductive paste composition which includes metallic particles, glass frit including lead oxide, silicon dioxide, and silver or a silver-containing compound, and an organic vehicle.

The invention also provides a solar cell produced by applying the electroconductive paste of the invention to a silicon wafer and firing the silicon wafer.

Another aspect of the invention is a solar cell module including electrically interconnected solar cells according to the present invention.

The invention also provides a method of producing a solar cell, including the steps of providing a silicon wafer having a front side and a backside, applying the electroconductive paste of the invention to the silicon wafer, and firing the silicon wafer.

### Detailed Description

The invention relates to electroconductive paste compositions useful for forming electrodes on a solar cell. While not limited to such an application, such pastes may be used to form electrodes on the front side of a solar cell, providing the path by which conductivity occurs between solar cells. The electroconductive paste composition preferably comprises conductive metallic particles, an organic vehicle and glass frit which includes silver or a silver-containing compound.

### Electroconductive Paste

A desired electroconductive paste is one which is highly conductive, so as to optimize the efficiency of the resulting solar cell. The components of the paste and proportions thereof may be selected such that the paste produces an electrode with optimal electrical properties and is easily printable. One way to achieve improved electrical properties is to increase the amount of contact made between the electroconductive paste and the underlying silicon substrate.

The electroconductive paste according to the invention is generally comprised of conductive metallic particles, an organic vehicle, and glass frit. According to one embodiment, the electroconductive paste comprises about 70-99 wt % metallic particles, about 0.1-15 wt % glass frit, about 1-15 wt % organic vehicle, based upon 100% total weight of the paste. According to one embodiment, the electroconductive paste further includes inorganic and organic additives.

### Glass Frit

The glass frit of the invention acts as an adhesion media, facilitating the bonding between the metallic conductive particles and the silicon substrate, and thus providing reliable electrical contact performance during the lifetime of the solar device. Specifically, the glass frit etches through the surface layers (e.g., antireflective layer) of the silicon substrate, such that effective contact can be made between the electroconductive paste and the silicon wafer. Certain glass compositions result in high contact resistance at the silicon interface, due to the insulating effect of the glass between the electroconductive paste and silicon wafer. The glass frit of the invention has the advantage of providing lower contact resistance and higher overall cell efficiency.

According to one embodiment, the glass frit is about 0.1-20 wt %, preferably about 0.2-12 wt %, more preferably about 0.3-8 wt %, and most preferably about 0.5-5 wt.%, based upon 100% total weight of the electroconductive paste.

Preferred glass frits are powders of amorphous or partially crystalline solids which exhibit a glass transition. The glass transition temperature T_{g} is the temperature at which an amorphous substance transforms from a rigid solid to a partially mobile undercooled melt upon heating. Methods for the determination of the glass transition temperature are well known to the person skilled in the art. Specifically, the glass transition temperature Tg is determined using a DSC apparatus SDT Q600 (commercially available from TA Instruments) which simultaneously records differential scanning calorimetry (DSC) and thermogravimetric analysis (TGA) curves. The instrument is equipped with a horizontal balance and furnace with a platinum/platinum-rhodium (type R) thermocouple. The sample holders used are aluminum oxide ceramic crucibles with a capacity of about 40-90 µl. For the measurements and data evaluation, the measurement software Q Advantage; Thermal Advantage Release 5.4.0 and Universal Analysis 2000, version 4.5A Build 4.5.0.5 is applied respectively. As pan for reference and sample, aluminum oxide pan having a volume of about 85 µl is used. An amount of about 10-50 mg of the sample is weighted into the sample pan with an accuracy of 0.01 mg. The empty reference pan and the sample pan are placed in the apparatus, the oven is closed and the measurement started. A heating rate of 10 K/min is employed from a starting temperature of 25 °C to an end temperature of 1000 °C. The balance in the instrument is always purged with nitrogen (N₂ 5.0) and the oven is purged with synthetic air (80% N₂ and 20% O₂ from Linde) with a flow rate of 50 ml/min. The first step in the DSC signal is evaluated as glass transition using the software described above, and the determined onset value is taken as the temperature for Tg.

Preferably, the glass transition temperature is below the desired firing temperature of the electroconductive paste. According to the invention, preferred glass frits have a glass transition temperature in a range from about 200 °C to about 700 °C, preferably in a range from about 250 °C to about 650 °C, and most preferably in a range from about 250 °C to about 500 °C.

In the context of the invention, the glass frit preferably comprises silver or a silver-containing compound. Without being bound by any particular theory, Applicants believe that the silver or silver-containing compound increases the density of the glass frit, and results in minimal formation of gaps at the interface between the glass and the silicon substrate, and an improved interface between the glass and the metallic particles. Further, the properties of a glass composition, including its glass transition temperature and melting temperature, can be tailored by altering the amount of silver present in the glass. This allows for adjustable processing parameters to meet a variety of temperature-specific applications.

Additionally, boron, which is commonly present in glass frits, may be replaced by silver or a silver-containing compound. The presence of boron in the glass frit tends to cause the glass frit to crystallize quickly during firing of the resulting electroconductive paste, which in turn negatively affects the glass flow behavior. In one embodiment, the glass frit is free or substantially free of boron.

According to one embodiment, the glass frit comprises about 0.1-30 wt% silver or a silver-containing compound, preferably about 0.1-20 wt%, and more preferably about 5-10 wt%, based upon 100% total weight of the glass frit. Glass frits having a silver content above 30 wt% may result in phase separation during melting of the glass. Suitable examples of silver-containing compounds include, but are not limited to, oxides of silver, such AgO and Ag₂O, halides of silver, such as AgF, AgCl, AgBr, and AgI, and chalcogenides of silver, such as Ag₂S, Ag₂Se, Ag₂Te, and combinations thereof. According to a preferred embodiment, Ag₂O is used.

In addition to silver or a silver-containing compound, other elements, oxides, and/or compounds which generate oxides upon heating, or mixtures thereof, may be included in the glass frit. In a preferred embodiment, the glass frit comprises lead oxide (PbO), silicon dioxide (SiO₂) and silver or a silver-containing compound. In one embodiment, the glass frit comprises about 10-99 wt% PbO, preferably about 70-99 wt% PbO, and more preferably about 70-90 wt%, and more preferably about 75-85 wt% PbO, based upon 100% total weight of the glass. In another embodiment, the glass frit comprises about 10-70 wt% PbO, preferably about 20-50 wt% PbO, and most preferably about 20-30 wt%, based upon 100% total weight of the glass. The glass frit may comprise about 0.1-15 wt% SiO₂, preferably 5-15 wt% SiO₂, and more preferably 5-10 wt% SiO₂, based upon 100% total weight of the glass.

In another embodiment, the glass frit may comprise other lead-based compounds including, but not limited to, salts of lead halides, lead chalcogenides, lead carbonate, lead sulfate, lead phosphate, lead nitrate and organometallic lead compounds or compounds that can form lead oxides or salts during thermal decomposition. In an alternative embodiment, the glass frit may be lead-free.

In addition to the components recited above, the glass frit may also comprise other compounds used to improve contact properties of the resulting electroconductive paste. For example, the glass frit may also comprise oxides or other compounds of Li, Na, K, Rb, Cs, Mg, Ca, Sr, Ba, V, Zr, Mo, Mn, Zn, B, P, Sn, Ga, Ge, In, Al, Sb, Bi, Ce, Cu, Ni, Cr, Fe, or Co, any combinations thereof Examples of such oxides and compounds include, but are not limited to, germanium oxides, vanadium oxides, molybdenum oxides, niobium oxides, lithium oxides, tin oxides, indium oxides, rare earth oxides (such as La₂O₃ or cerium oxides), phosphorus oxides, transition metal oxides (such as copper oxides and chromium oxides), metal halides (such as lead fluorides and zinc fluorides), and combinations thereof. In a preferred embodiment, the glass frit comprises aluminum oxide (e.g., Al₂O₃), zinc oxide (ZnO), or both. Such oxides and compounds are preferably present in a total amount of about 0.1-15 wt% of the glass frit. In another preferred embodiment, the glass frit also comprises tellurium dioxide (TeO₂). Preferably, the glass frit comprises about 0.1 to about 25 mol% tellurium dioxide. In another embodiment, the glass frit does not contain an oxide of tellurium (e.g., TeO₂).

According to one embodiment, the glass frit comprises about 0.1 to about 30 mol%, more preferably about 1 to about 10 mol%, of silver or a silver-containing compound; about 40-75 mol%, preferably about 60-75 mol%, PbO; about 20-30 mol% SiO₂; about 1-10 mol%, preferably about 2-5 mol% Al₂O₃; and about 1-10 mol%, preferably about 2-5 mol%, ZnO.

It is well known to the person skilled in the art that glass frit particles can exhibit a variety of shapes, surface natures, sizes, surface area to volume ratios and coating layers. A large number of shapes of glass frit particles are known in the art. Some examples are spherical, angular, elongated (rod or needle like) and flat (sheet like). Glass frit particles may also be present as a combination of particles of different shapes. Glass frit particles with a shape, or combination of shapes, which favor improved electrical contact of the produced electrode are preferred according to the invention. One way to characterize such shapes without considering the surface nature of the particles is through the following parameters: length, width and thickness. In the context of the invention, the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle.

In one embodiment according to the invention, glass frit particles with shapes as uniform as possible are preferred (i.e. shapes in which the ratios relating the length, the width and the thickness are as close as possible to 1, preferably all ratios lying in a range from about 0.7 to about 1.5, more preferably in a range from about 0.8 to about 1.3 and most preferably in a range from about 0.9 to about 1.2). Examples of preferred shapes for the glass frit particles in this embodiment are spheres and cubes, or combinations thereof, or combinations of one or more thereof with other shapes.

While glass frit particles may have an irregular shape, the particle size may be approximately represented as the diameter of the "equivalent sphere" which would give the same measurement result Typically, glass frit particles in any given sample do not exist in a single size, but are distributed in a range of sizes, i.e., particle size distribution. One parameter characterizing particle size distribution is d₅₀. d₅₀ is the median diameter or the medium value of the particle size distribution. It is the value of the particle diameter at 50% in the cumulative distribution. Other parameters of particle size distribution include d₁₀, which represents the particle diameter at which 10% cumulative (from 0 to 100%) of the particles are smaller, and d₉₀, which represents the particle diameter at which 90% cumulative (from 0 to 100%) of the particles are smaller. Particle size distribution may be measured via laser diffraction, dynamic light scattering, imagine, electrophoretic light scattering, or any other methods known in the art. Specifically, particle size according to the invention is determined in accordance with ISO 13317-3:2001. A SediGraph III 5120 instrument, with software SediGraph 5120 (manufactured by Micromeritics Instrument Corp. of Norcross, Georgia), which operates according to X-ray gravitational technique, is used for the measurement. A sample of about 400 to 600 mg is weighed into a 50 ml glass beaker and 40 ml of Sedisperse P11 (from Micromeritics, with a density of about 0.74 to 0.76 g/cm³ and a viscosity of about 1.25 to 1.9 mPa·s) are added as suspending liquid. A magnetic stirring bar is added to the suspension. The sample is dispersed using an ultrasonic probe Sonifer 250 (from Branson) operated at power level 2 for 8 minutes while the suspension is stirred with the stirring bar at the same time. This pre-treated sample is placed in the instrument and the measurement started. The temperature of the suspension is recorded (typical range 24 °C to 45 °C) and for calculation data of measured viscosity for the dispersing solution at this temperature are used. Using density and weight of the sample (10.5 g/cm³ for silver) the particle size distribution is determined and given as d₁₀, d₅₀, and d₉₀.

It is preferred according to the invention that the median particle diameter d₅₀ of the glass frit particles lie in a range from about 0.1 to 10 µm, more preferably in a range from about 0.1 to 5 µm, and most preferably in a range from about 0.1 to 3.5 µm. In one embodiment of the invention, the glass frit particles have a d₁₀ greater than about 0.1 µm, preferably greater than about 0.15 µm, and more preferably greater than about 0.2 µm. In one embodiment of the invention, the glass frit particles have a d₉₀ less than about 10 µm, preferably less than about 5 µm, and more preferably less than about 4.5 µm.

One way to characterize the shape and surface of a particle is by its surface area to volume ratio. The surface area to volume ratio, or specific surface area, may be measured by the BET (Brunauer-Emmett-Teller) method, which is known in the art. Specifically, BET measurements are made in accordance with DIN ISO 9277:1995. A Monosorb instrument (manufactured by Quantachrome Instruments), which operates according to the SMART method (Sorption Method with Adaptive dosing Rate), is used for the measurement. Samples are prepared for analysis in the built-in degas station. Flowing gas sweeps away impurities, resulting in a clean surface upon which adsorption may occur. The sample can be heated to a user-selectable temperature with the supplied heating mantle. Digital temperature control and display are mounted on the instrument front panel. After degassing is complete, the sample cell is transferred to the analysis station. Quick connect fittings automatically seal the sample cell during transfer. With the push of a single button, analysis commences. A dewar flask filled with coolant is automatically raised, immersing the sample cell and causing adsorption. The instrument detects when adsorption is complete (2-3 minutes), automatically lowers the dewar flask, and gently heats the sample cell back to room temperature using a built-in hot-air blower. As a result, the desorbed gas signal is displayed on a digital meter and the surface area is directly presented on a front panel display. The entire measurement (adsorption and desorption) cycle typically requires less than six minutes. The technique uses a high sensitivity, thermal conductivity detector to measure the change in concentration of an adsorbate/inert carrier gas mixture as adsorption and desorption proceed. When integrated by the on-board electronics and compared to calibration, the detector provides the volume of gas adsorbed or desorbed. A built-in microprocessor ensures linearity and automatically computes the sample's BET surface area in m2/g.

In one embodiment according to the invention, glass frit particles have a specific surface area of about 0.5 m²/g to about 11 m²/g, preferably about 1 m²/g to about 10 m²/g, and most preferably about 2 m²/g to about 8 m²/g.

According to another embodiment, the glass frit particles may include a surface coating. Any such coating known in the art and which is considered to be suitable in the context of the invention can be employed on the glass frit particles. Preferred coatings according to the invention are those coatings which promote improved adhesion of the electroconductive paste. If such a coating is present, it is preferred that the coating correspond to no more than about 10 wt%, preferably no more than about 8 wt%, most preferably no more than about 5 wt%, in each case based on the total weight of the glass frit particles.

### Conductive Metallic Particles

Conductive metallic particles in the context of the invention are those which exhibit optimal conductivity and which effectively sinter upon firing, such that they yield electrodes with high conductivity and low contact resistance. Conductive metallic particles known in the art suitable for uses as solar cell surface electrodes that are also easy to solder, and mixtures or alloys thereof, can be used with the present invention. Preferred metallic particles according to the invention are elemental metals, alloys, metal derivatives, mixtures of at least two metals, mixtures of at least two alloys or mixtures of at least one metal with at least one alloy.

Metals which can be employed as the metallic particles include silver, copper, gold, aluminum, zinc, palladium, nickel or lead, and any mixtures of at least two thereof. Alloys which can be employed as metallic particles according to the invention include alloys containing at least one metal selected from the list of silver, copper, aluminum, zinc, nickel, tungsten, lead and palladium, or mixtures or two or more of those alloys. In another embodiment, the metallic particles comprise a metal or alloy coated with one or more different metals or alloys, for example silver particles coated with aluminum or copper particles coated with silver.

In one embodiment, the conductive metallic particles are at least one of silver, copper, aluminum, gold, and nickel, or any mixtures or alloys thereof. In a preferred embodiment, the metallic particles are silver. The silver may be present as elemental silver, a silver alloy, or silver derivate. Suitable silver derivatives include, for example, silver alloys and/or silver salts, such as silver halides (e.g., silver chloride), silver oxide, silver nitrate, silver acetate, silver trifluoroacetate, silver orthophosphate, and combinations thereof. The electroconductive paste comprises about 50-99 wt% metallic particles, preferably about 60-99 wt%, more preferably about 70-99 wt%, and most preferably about 80-95 wt%, based upon 100% total weight of the paste.

As additional constituents of the metallic particles, further to the above-mentioned constituents, those materials which contribute to more favorable contact properties and electrical conductivity are preferred. For example, the metallic particles may be present with a surface coating. Any such coating known in the art, and which is considered to be suitable in the context of the invention, may be employed on the metallic particles. Preferred coatings are those coatings which promote sintering and adhesive performance of the resulting electroconductive paste. If such a coating is present, it is preferred that the coating correspond to no more than about 10 wt%, preferably no more than about 8 wt%, and most preferably no more than about 5 wt%, based on 100% total weight of the metallic particles.

The conductive particles can exhibit a variety of shapes, surfaces, sizes, surface area to volume ratios, oxygen content and oxide layers. A large number of shapes are known in the art. Some examples are spherical, angular, elongated (rod or needle like) and flat (sheet like). Conductive metallic particles may also be present as a combination of particles of different shapes. Metallic particles with a shape, or combination of shapes, which favors sintering and adhesion are preferred according to the invention. One way to characterize such shapes without considering the surface nature of the particles is through the following parameters: length, width and thickness, as set forth herein.

In one embodiment, metallic particles with shapes as uniform as possible are preferred (i.e. shapes in which the ratios relating the length, the width and the thickness are as close as possible to 1, preferably all ratios lying in a range from about 0.7 to about 1.5, more preferably in a range from about 0.8 to about 1.3 and most preferably in a range from about 0.9 to about 1.2). Examples of preferred shapes for the metallic particles in this embodiment are spheres and cubes, or combinations thereof, or combinations of one or more thereof with other shapes. In another embodiment according to the invention, metallic particles are preferred which have a shape of low uniformity, preferably with at least one of the ratios relating the dimensions of length, width and thickness being above about 1.5, more preferably above about 3 and most preferably above about 5. Preferred shapes according to this embodiment are flake shaped, rod or needle shaped, or a combination of flake shaped, rod or needle shaped with other shapes.

A variety of surface types of the conductive particles are known in the art. Surface types which favor effective sintering and yield advantageous electrical conductivity of the resulting electrode are preferred.

It is preferred according to the invention that the median particle diameter d₅₀, as discussed herein, of the metallic particles lie in a range from about 0.1 to 10 µm, more preferably in a range from about 0.1 to 5 µm, and more preferably in a range from about 0.5 to 3.5 µm. In one embodiment of the invention, the metallic particles have a d₁₀ greater than about 0.1 µm, preferably greater than about 0.2 µm, and more preferably greater than about 0.3 µm. In one embodiment of the invention, the metallic particles have a d₉₀ less than about 10 µm, preferably less than about 8 µm, and more preferably less than about 6 µm.

In one embodiment, the metallic particles have a specific surface area, as set forth herein, of about 0.1 m²/g to about 5 m²/g, more preferably about 0.2 m²/g to about 2 m²/g, and most preferably about 0.2 m²/g to about 0.8 m²/g.

### Organic Vehicle

Preferred organic vehicles in the context of the invention are solutions, emulsions or dispersions based on one or more solvents, preferably an organic solvent, which ensure that the constituents of the electroconductive paste are present in a dissolved, emulsified or dispersed form. Preferred organic vehicles are those which provide optimal stability of constituents within the electroconductive paste and endow the electroconductive paste with a viscosity allowing effective printability.

In one embodiment, the organic vehicle comprises an organic solvent and one or more of a binder (e.g., a polymer), a surfactant or a thixotropic agent, or any combination thereof. For example, in one embodiment, the organic vehicle comprises one or more binders in an organic solvent.

Preferred binders in the context of the invention are those which contribute to the formation of an electroconductive paste with favorable stability, printability, viscosity and sintering properties. Binders are well known in the art. Preferred binders according to the invention (which often fall within the category termed "resins") are polymeric binders, monomeric binders, and binders which are a combination of polymers and monomers. Polymeric binders can also be copolymers wherein at least two different monomeric units are contained in a single molecule. Preferred polymeric binders are those which carry functional groups in the polymer main chain, those which carry functional groups off of the main chain and those which carry functional groups both within the main chain and off of the main chain. Preferred polymers carrying functional groups in the main chain are for example polyesters, substituted polyesters, polycarbonates, substituted polycarbonates, polymers which carry cyclic groups in the main chain, poly-sugars, substituted poly-sugars, polyurethanes, substituted polyurethanes, polyamides, substituted polyamides, phenolic resins, substituted phenolic resins, copolymers of the monomers of one or more of the preceding polymers, optionally with other comonomers, or a combination of at least two thereof. According to one embodiment, the binder may be polyvinyl butyral or polyethylene. Preferred polymers which carry cyclic groups in the main chain are for example polyvinylbutylate (PVB) and its derivatives and poly-terpineol and its derivatives or mixtures thereof. Preferred poly-sugars are for example cellulose and alkyl derivatives thereof, preferably methyl cellulose, ethyl cellulose, hydroxyethyl cellulose, propyl cellulose, hydroxypropyl cellulose, butyl cellulose and their derivatives and mixtures of at least two thereof. Other preferred polymers include cellulose ester resins, such as cellulose acetate propionate, cellulose acetate butyrate, and mixtures thereof. Preferably, those cellulose ester resins disclosed in U.S. Patent Publication No. 2013/0180583, which is incorporated herein by reference, are used. Preferred polymers which carry functional groups off of the main polymer chain are those which carry amide groups, those which carry acid and/or ester groups, often called acrylic resins, or polymers which carry a combination of aforementioned functional groups, or a combination thereof. Preferred polymers which carry amide off of the main chain are for example polyvinyl pyrrolidone (PVP) and its derivatives. Preferred polymers which carry acid and/or ester groups off of the main chain are for example polyacrylic acid and its derivatives, polymethacrylate (PMA) and its derivatives or polymethylmethacrylate (PMMA) and its derivatives, or a mixture thereof. Preferred monomeric binders according to the invention are ethylene glycol based monomers, terpineol resins or rosin derivatives, or a mixture thereof. Preferred monomeric binders based on ethylene glycol are those with ether groups, ester groups or those with an ether group and an ester group, preferred ether groups being methyl, ethyl, propyl, butyl, pentyl hexyl and higher alkyl ethers, the preferred ester group being acetate and its alkyl derivatives, preferably ethylene glycol monobutylether monoacetate or a mixture thereof. Alkyl cellulose, preferably ethyl cellulose, its derivatives and mixtures thereof with other binders from the preceding lists of binders or otherwise are the most preferred binders in the context of the invention. The binder may be present in an amount between about 0.1 and 10 wt%, preferably between about 0.1-8 wt%, and more preferably between about 0.5-7 wt%, based upon 100% total weight of the organic vehicle.

Preferred solvents according to the invention are constituents of the electroconductive paste which are removed from the paste to a significant extent during firing, preferably those which are present after firing with an absolute weight reduced by at least about 80% compared to before firing, preferably reduced by at least about 95% compared to before firing. Preferred solvents according to the invention are those which allow an electroconductive paste to be formed which has favorable viscosity, printability, stability and sintering characteristics. All solvents which are known in the art, and which are considered to be suitable in the context of this invention, may be employed as the solvent in the organic vehicle. According to the invention, preferred solvents are those which allow the preferred high level of printability of the electroconductive paste as described above to be achieved. Preferred solvents according to the invention are those which exist as a liquid under standard ambient temperature and pressure (SATP) (298.15 K, 25 °C, 77 °F), 100 kPa (14.504 psi, 0.986 atm), preferably those with a boiling point above about 90 °C and a melting point above about -20 °C. Preferred solvents according to the invention are polar or non-polar, protic or aprotic, aromatic or non-aromatic. Preferred solvents according to the invention are mono-alcohols, di-alcohols, poly-alcohols, mono-esters, di-esters, poly-esters, mono-ethers, di-ethers, poly-ethers, solvents which comprise at least one or more of these categories of functional group, optionally comprising other categories of functional group, preferably cyclic groups, aromatic groups, unsaturated bonds, alcohol groups with one or more O atoms replaced by heteroatoms, ether groups with one or more O atoms replaced by heteroatoms, esters groups with one or more O atoms replaced by heteroatoms, and mixtures of two or more of the aforementioned solvents. Preferred esters in this context are di-alkyl esters of adipic acid, preferred alkyl constituents being methyl, ethyl, propyl, butyl, pentyl, hexyl and higher alkyl groups or combinations of two different such alkyl groups, preferably dimethyladipate, and mixtures of two or more adipate esters. Preferred ethers in this context are diethers, preferably dialkyl ethers of ethylene glycol, preferred alkyl constituents being methyl, ethyl, propyl, butyl, pentyl, hexyl and higher alkyl groups or combinations of two different such alkyl groups, and mixtures of two diethers. Preferred alcohols in this context are primary, secondary and tertiary alcohols, preferably tertiary alcohols, terpineol and its derivatives being preferred, or a mixture of two or more alcohols. Preferred solvents which combine more than one different functional groups are 2,2,4-trimethyl-1,3-pentanediol monoisobutyrate, often called texanol, and its derivatives, 2-(2-ethoxyethoxy)ethanol, often known as carbitol, its alkyl derivatives, preferably methyl, ethyl, propyl, butyl, pentyl, and hexyl carbitol, preferably hexyl carbitol or butyl carbitol, and acetate derivatives thereof, preferably butyl carbitol acetate, or mixtures of at least two of the aforementioned. The organic solvent may be present in an amount between about 40 and 90 wt% based upon 100% total weight of the organic vehicle.

The organic vehicle may also comprise one or more surfactants and/or additives. Preferred surfactants in the context of the invention are those which contribute to the formation of an electroconductive paste with favorable stability, printability, viscosity and sintering properties. Surfactants are well known to the person skilled in the art. All surfactants which are known in the art, and which are considered to be suitable in the context of this invention, may be employed as the surfactant in the organic vehicle. Preferred surfactants in the context of the invention are those based on linear chains, branched chains, aromatic chains, fluorinated chains, siloxane chains, polyether chains and combinations thereof. Preferred surfactants are single chained, double chained or poly chained. Preferred surfactants according to the invention may have non-ionic, anionic, cationic, amphiphilic, or zwitterionic heads. Preferred surfactants are polymeric and monomeric or a mixture thereof. Preferred surfactants according to the invention can have pigment affinic groups, preferably hydroxyfunctional carboxylic acid esters with pigment affinic groups (e.g., DISPERBYK®-108, manufactured by BYK USA, Inc.), acrylate copolymers with pigment affinic groups (e.g., DISPERBYK®-116, manufactured by BYK USA, Inc.), modified polyethers with pigment affinic groups (e.g., TEGO® DISPERS 655, manufactured by Evonik Tego Chemie GmbH), other surfactants with groups of high pigment affinity (e.g., TEGO® DISPERS 662 C, manufactured by Evonik Tego Chemie GmbH). Other preferred polymers according to the invention not in the above list are polyethylene oxide, polyethylene glycol and its derivatives, and alkyl carboxylic acids and their derivatives or salts, or mixtures thereof. The preferred polyethylene glycol derivative according to the invention is poly(ethyleneglycol)acetic acid. Preferred alkyl carboxylic acids are those with fully saturated and those with singly or poly unsaturated alkyl chains or mixtures thereof. Preferred carboxylic acids with saturated alkyl chains are those with alkyl chains lengths in a range from about 8 to about 20 carbon atoms, preferably C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid), or salts or mixtures thereof. Preferred carboxylic acids with unsaturated alkyl chains are C₁₈H₃₄O₂ (oleic acid) and C₁₈H₃₂O₂ (linoleic acid). The preferred monomeric surfactant according to the invention is benzotriazole and its derivatives. The surfactant may be present in the organic vehicle in an amount of about 0-10 wt%, preferably about 0-8 wt%, and more preferably about 0.01-6 wt%, based upon 100% total weight of the organic vehicle.

Preferred additives in the organic vehicle are those additives which are distinct from the aforementioned vehicle components and which contribute to favorable properties of the electroconductive paste, such as advantageous viscosity and adhesion to the underlying substrate. Additives known in the art, and which are considered to be suitable in the context of the invention, may be employed as an additive in the organic vehicle. Preferred additives according to the invention are thixotropic agents, viscosity regulators, stabilizing agents, inorganic additives, thickeners, emulsifiers, dispersants or pH regulators. Preferred thixotropic agents in this context are carboxylic acid derivatives, preferably fatty acid derivatives or combinations thereof. Preferred fatty acid derivatives are C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) C₁₈H₃₄O₂ (oleic acid), C₁₈H₃₂O₂ (linoleic acid) or combinations thereof. A preferred combination comprising fatty acids in this context is castor oil.

In one embodiment, the organic vehicle is present in the electroconductive paste in an amount of about 1-20 wt%, more preferably about 1-15 wt%, and most preferably about 5-15 wt%, based upon 100% total weight of the paste.

### Additives

Preferred additives in the context of the invention are components added to the electroconductive paste, in addition to the other components explicitly mentioned, which contribute to increased performance of the electroconductive paste, of the electrodes produced thereof, or of the resulting solar cell. All additives known in the art, and which are considered suitable in the context of the invention, may be employed as additives in the electroconductive paste. In addition to additives present in the glass frit and in the vehicle, additives can also be present in the electroconductive paste. Preferred additives according to the invention include thixotropic agents, viscosity regulators, emulsifiers, stabilizing agents or pH regulators, inorganic additives, thickeners and dispersants, or a combination of at least two thereof. Preferred inorganic organometallic additives in this context according to the invention are Mg, Ni, Te, W, Zn, Mg, Gd, Ce, Zr, Ti, Mn, Sn, Ru, Co, Fe, Rh, V, Y, Sb, P, Cu and Cr or a combination of at least two thereof, preferably Zn, Sb, Mn, Ni, W, Te, Rh, V, Y, Sb, P and Ru, or a combination of at least two thereof, oxides thereof, compounds which can generate those metal oxides on firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned. Those additives disclosed in WO 2012/058358 A1, which is incorporated herein by reference, may be used in the electroconductive paste.

According to one embodiment, an additive or additives are present in the paste composition at about 0.1-10 wt%, preferably about 0.1-5 wt%, and more preferably about 0.1-2 wt%, based upon 100% total weight of the paste.

### Forming the Electroconductive Paste Composition

To form an electroconductive paste, the glass frit materials are combined with the conductive metallic particles and organic vehicle using any method known in the art for preparing a paste composition. The method of preparation is not critical, as long as it results in a homogenously dispersed paste. The components can be mixed, such as with a mixer, then passed through a three roll mill, for example, to make a dispersed uniform paste. In addition to mixing all of the components together simultaneously, the raw glass frit materials can be co-milled with silver particles, for example, in a ball mill for 2-24 hours to achieve a homogenous mixture of glass frit and silver particles, which are then combined with the organic solvent in a mixer.

### Solar Cells

In another aspect, the invention relates to a solar cell. In one embodiment, the solar cell comprises a semiconductor substrate (e.g., a silicon wafer) and an electroconductive paste composition according to any of the embodiments described herein.

In another aspect, the invention relates to a solar cell prepared by a process which includes applying an electroconductive paste composition according to any of the embodiments described herein to a semiconductor substrate (e.g., a silicon wafer) and firing the semiconductor substrate.

### Silicon Wafer

Preferred wafers according to the invention have regions, among other regions of the solar cell, capable of absorbing light with high efficiency to yield electron-hole pairs and separating holes and electrons across a boundary with high efficiency, preferably across a p-n junction boundary. Preferred wafers according to the invention are those comprising a single body made up of a front doped layer and a back doped layer.

Preferably, the wafer comprises appropriately doped tetravalent elements, binary compounds, tertiary compounds or alloys. Preferred tetravalent elements in this context are silicon, germanium, or tin, preferably silicon. Preferred binary compounds are combinations of two or more tetravalent elements, binary compounds of a group III element with a group V element, binary compounds of a group II element with a group VI element or binary compounds of a group IV element with a group VI element Preferred combinations of tetravalent elements are combinations of two or more elements selected from silicon, germanium, tin or carbon, preferably SiC. The preferred binary compounds of a group III element with a group V element is GaAs. According to a preferred embodiment of the invention, the wafer is silicon. The foregoing description, in which silicon is explicitly mentioned, also applies to other wafer compositions described herein.

The p-n junction boundary is located where the front doped layer and back doped layer of the wafer meet. In an n-type solar cell, the back doped layer is doped with an electron donating n-type dopant and the front doped layer is doped with an electron accepting or hole donating p-type dopant. In a p-type solar cell, the back doped layer is doped with p-type dopant and the front doped layer is doped with n-type dopant. According to a preferred embodiment of the invention, a wafer with a p-n junction boundary is prepared by first providing a doped silicon substrate and then applying a doped layer of the opposite type to one face of that substrate.

Doped silicon substrates are well known in the art. The doped silicon substrate can be prepared by any method known in the art and considered suitable for the invention. Preferred sources of silicon substrates according to the invention are mono-crystalline silicon, multi-crystalline silicon, amorphous silicon and upgraded metallurgical silicon, most preferably mono-crystalline silicon or multi-crystalline silicon. Doping to form the doped silicon substrate can be carried out simultaneously by adding the dopant during the preparation of the silicon substrate, or it can be carried out in a subsequent step. Doping subsequent to the preparation of the silicon substrate can be carried out by gas diffusion epitaxy, for example. Doped silicon substrates are also readily commercially available. According to one embodiment, the initial doping of the silicon substrate may be carried out simultaneously to its formation by adding dopant to the silicon mix. According to another embodiment, the application of the front doped layer and the highly doped back layer, if present, may be carried out by gas-phase epitaxy. This gas phase epitaxy is preferably carried out within a temperature range of about 500 °C to about 900 °C, more preferably from about 600 °C to about 800 °C, and most preferably from about 650 °C to about 750 °C, at a pressure in a range from about 2 kPa to about 100 kPa, preferably from about 10 to about 80 kPa, and most preferably from about 30 to about 70 kPa.

It is known in the art that silicon substrates can exhibit a number of shapes, surface textures and sizes. The shape of the substrate may include cuboid, disc, wafer and irregular polyhedron, to name a few. According to a preferred embodiment of the invention, the wafer is a cuboid with two dimensions which are similar, preferably equal, and a third dimension which is significantly smaller than the other two dimensions. The third dimension may be at least 100 times smaller than the first two dimensions.

Further, a variety of surface types are known in the art. According to the invention, silicon substrates with rough surfaces are preferred. One way to assess the roughness of the substrate is to evaluate the surface roughness parameter for a sub-surface of the substrate, which is small in comparison to the total surface area of the substrate, preferably less than about one hundredth of the total surface area, and which is essentially planar. The value of the surface roughness parameter is given by the ratio of the area of the sub-surface to the area of a theoretical surface formed by projecting that sub-surface onto the flat plane best fitted to the sub-surface by minimizing mean square displacement. A higher value of the surface roughness parameter indicates a rougher, more irregular surface and a lower value of the surface roughness parameter indicates a smoother, more even surface. According to the invention, the surface roughness of the silicon substrate is preferably modified so as to produce an optimum balance between a number of factors including, but not limited to, light absorption and adhesion to the surface.

The two larger dimensions of the silicon substrate can be varied to suit the application required of the resultant solar cell. It is preferred according to the invention for the thickness of the silicon wafer to be below about 0.5 mm, more preferably below about 0.3 mm, and most preferably below about 0.2 mm. Some wafers have a minimum thickness of 0.01 mm or more.

It is preferred according to the invention that the front doped layer be thin in comparison to the back doped layer. It is also preferred that the front doped layer have a thickness lying in a range from about 0.1 to about 10 µm, preferably in a range from about 0.1 to about 5 µm and most preferably in a range from about 0.1 to about 2 µm.

A highly doped layer can be applied to the back face of the silicon substrate between the back doped layer and any further layers. Such a highly doped layer is of the same doping type as the back doped layer and such a layer is commonly denoted with a + (n+-type layers are applied to n-type back doped layers and p+-type layers are applied to p-type back doped layers). This highly doped back layer serves to assist metallization and improve electroconductive properties. It is preferred according to the invention for the highly doped back layer, if present, to have a thickness in a range from about 1 to about 100 µm, preferably in a range from about 1 to about 50 µm and most preferably in a range from about 1 to about 15 µm.

### Dopants

Preferred dopants are those which, when added to the silicon wafer, form a p-n junction boundary by introducing electrons or holes into the band structure. It is preferred according to the invention that the identity and concentration of these dopants is specifically selected so as to tune the band structure profile of the p-n junction and set the light absorption and conductivity profiles as required. Preferred p-type dopants according to the invention are those which add holes to the silicon wafer band structure. All dopants known in the art and which are considered suitable in the context of the invention can be employed as p-type dopants. Preferred p-type dopants according to the invention are trivalent elements, particularly those of group 13 of the periodic table. Preferred group 13 elements of the periodic table in this context include, but are not limited to, boron, aluminum, gallium, indium, thallium, or a combination of at least two thereof, wherein boron is particularly preferred.

Preferred n-type dopants according to the invention are those which add electrons to the silicon wafer band structure. All dopants known in the art and which are considered to be suitable in the context of the invention can be employed as n-type dopants. Preferred n-type dopants according to the invention are elements of group 15 of the periodic table. Preferred group 15 elements of the periodic table in this context include nitrogen, phosphorus, arsenic, antimony, bismuth or a combination of at least two thereof, wherein phosphorus is particularly preferred.

As described above, the various doping levels of the p-n junction can be varied so as to tune the desired properties of the resulting solar cell. Doping levels are measured using secondary ion mass spectroscopy.

According to certain embodiments, the semiconductor substrate (i.e., silicon wafer) exhibits a sheet resistance above about 60 Ω/□, such as above about 65 Ω/□, 70 Ω/□, 90 Ω/□ or 100 Ω/□. For measuring the sheet resistance of a doped silicon wafer surface, the device "GP4-Test Pro" equipped with software package "GP-4 Test 1.6.6 Pro" (available from GP Solar GmbH) is used. For the measurement, the four point measuring principle is applied. The two outer probes apply a constant current and two inner probes measure the voltage. The sheet resistance is deduced using the Ohmic law in Ω/□. To determine the average sheet resistance, the measurement is performed on 25 equally distributed spots of the wafer. In an air conditioned room with a temperature of 22 ± 1 °C, all equipment and materials are equilibrated before the measurement. To perform the measurement, the "GP-Test.Pro" is equipped with a 4-point measuring head (Part Number 04.01.0018) with sharp tips in order to penetrate the antireflection and/or passivation layers. A current of 10 mA is applied. The measuring head is brought into contact with the non metalized wafer material and the measurement is started. After measuring 25 equally distributed spots on the wafer, the average sheet resistance is calculated in Ω/□.

### Solar Cell Structure

A contribution to achieving at least one of the above described objects is made by a solar cell obtainable from a process according to the invention. Preferred solar cells according to the invention are those which have a high efficiency, in terms of proportion of total energy of incident light converted into electrical energy output, and those which are light and durable. At a minimum, a solar cell includes: (i) front electrodes, (ii) a front doped layer, (iii) a p-n junction boundary, (iv) a back doped layer, and (v) soldering pads. The solar cell may also include additional layers for chemical/mechanical protection.

### Antireflective Layer

According to the invention, an antireflective layer may be applied as the outer layer before the electrode is applied to the front face of the solar cell. All antireflective layers known in the art and which are considered to be suitable in the context of the invention can be employed. Preferred antireflective layers are those which decrease the proportion of incident light reflected by the front face and increase the proportion of incident light crossing the front face to be absorbed by the wafer. Antireflective layers which give rise to a favorable absorption/reflection ratio, are susceptible to etching by the electroconductive paste, are otherwise resistant to the temperatures required for firing of the electroconductive paste, and do not contribute to increased recombination of electrons and holes in the vicinity of the electrode interface, are preferred. Preferred antireflective layers according to the invention include SiNₓ, SiO₂, Al₂O₃, TiO₂ or mixtures of at least two thereof and/or combinations of at least two layers thereof. According to a preferred embodiment, the antireflective layer is SiNₓ, in particular where a silicon wafer is employed.

The thickness of antireflective layers is suited to the wavelength of the appropriate light. According to a preferred embodiment of the invention, the antireflective layers have a thickness in a range from about 20 to about 300 nm, more preferably in a range from about 40 to about 200 nm, and most preferably in a range from about 60 to about 90 nm.

### Passivation Layers

According to the invention, one or more passivation layers may be applied to the front and/or back side of the silicon wafer as an outer layer. The passivation layer(s) may be applied before the front electrode is formed, or before the antireflective layer is applied (if one is present). Preferred passivation layers are those which reduce the rate of electron/hole recombination in the vicinity of the electrode interface. Any passivation layer which is known in the art and which is considered to be suitable in the context of the invention can be employed. Preferred passivation layers according to the invention are silicon nitride, silicon dioxide and titanium dioxide. According to a most preferred embodiment, silicon nitride is used. It is preferred for the passivation layer to have a thickness in a range from about 0.1 nm to about 2 µm, more preferably in a range from about 10 nm to about 1 µm, and most preferably in a range from about 30 nm to about 200 nm.

### Additional Protective Layers

In addition to the layers described above which directly contribute to the principle function of the solar cell, further layers can be added for mechanical and chemical protection.

The cell can be encapsulated to provide chemical protection. Encapsulations are well known in the art and any encapsulation suitable for the invention can be employed. According to a preferred embodiment, transparent polymers, often referred to as transparent thermoplastic resins, are used as the encapsulation material, if such an encapsulation is present. Preferred transparent polymers in this context are silicon rubber and polyethylene vinyl acetate (PVA).

A transparent glass sheet may also be added to the front of the solar cell to provide mechanical protection to the front face of the cell. Transparent glass sheets are well known in the art and any transparent glass sheet suitable in the context of the invention may be employed.

A back protecting material may be added to the back face of the solar cell to provide mechanical protection. Back protecting materials are well known in the art and any back protecting material considered suitable in the context of the invention may be employed. Preferred back protecting materials according to the invention are those having good mechanical properties and weather resistance. The preferred back protection material according to the invention is polyethylene terephthalate with a layer of polyvinyl fluoride. It is preferred according to the invention for the back protecting material to be present underneath the encapsulation layer (in the event that both a back protection layer and encapsulation are present).

A frame material can be added to the outside of the solar cell to give mechanical support. Frame materials are well known in the art and any frame material considered suitable in the context of the invention may be employed. The preferred frame material according to the invention is aluminum.

### Method of Preparing a Solar Cell

A solar cell may be prepared by applying the electroconductive paste of the invention to an antireflection coating, such as silicon nitride, silicon oxide, titanium oxide or aluminum oxide, on a semiconductor substrate, such as a silicon wafer. A backside electroconductive paste is then applied to the backside of the solar cell to form soldering pads. An aluminum paste is then applied to the backside of the substrate, overlapping the edges of the soldering pads formed from the backside electroconductive paste, to form the BSF.

The electroconductive pastes may be applied in any manner known in the art and considered suitable in the context of the invention. Examples include, but are not limited to, impregnation, dipping, pouring, dripping on, injection, spraying, knife coating, curtain coating, brushing or printing or a combination of at least two thereof. Preferred printing techniques are ink-jet printing, screen printing, tampon printing, offset printing, relief printing or stencil printing or a combination of at least two thereof. It is preferred according to the invention that the electroconductive paste is applied by printing, preferably by screen printing. Specifically, the screens preferably have mesh opening with a diameter in a range from about 20 to about 100 µm, more preferably in a range from about 30 to about 80 µm, and most preferably in a range from about 30 to about 55 µm.

The substrate is then fired according to an appropriate profile. Firing is necessary to sinter the printed electroconductive paste so as to form solid conductive bodies (i.e., electrodes). Firing is well known in the art and can be effected in any manner considered suitable in the context of the invention. It is preferred that firing be carried out above the Tg of the glass frit materials.

According to the invention, the maximum temperature set for firing is below about 900 °C, preferably below about 860 °C. Firing temperatures as low as about 800 °C have been employed for obtaining solar cells. The firing temperature profile is typically set so as to enable the burnout of organic binder materials from the electroconductive paste composition, as well as any other organic materials present. The firing step is typically carried out in air or in an oxygen-containing atmosphere in a belt furnace. It is preferred according to the invention for firing to be carried out in a fast firing process with a total firing time in the range from about 30 s to about 3 minutes, more preferably in the range from about 30 s to about 2 minutes, and most preferably in the range from about 40 seconds to about 1 minute. The time above 600 °C is most preferably in a range from about 3 to 7 seconds. The substrate may reach a peak temperature in the range of about 700 to 900° C for a period of about 1 to 5 seconds. The firing may also be conducted at high transport rates, for example, about 100-700 cm/min, with resulting hold-up times of about 0.5 to 3 minutes. Multiple temperature zones, for example 3-12 zones, can be used to control the desired thermal profile.

Firing of electroconductive pastes on the front and back faces can be carried out simultaneously or sequentially. Simultaneous firing is appropriate if the electroconductive pastes applied to both faces have similar, preferably identical, optimum firing conditions. Where appropriate, it is preferred according to the invention for firing to be carried out simultaneously. Where firing is carried out sequentially, it is preferable according to the invention for the back electroconductive paste to be applied and fired first, followed by application and firing of the electroconductive paste to the front face.

### Measuring Performance of Electroconductive Paste

To measure the performance of a solar cell, a standard electrical test is conducted. A sample solar cell having both front side and backside pastes printed thereon is characterized using the "PSL DF" IV-tester (available from Berger Lichtechnik GmbH & Co. KG, of Pullach, Germany). All parts of the measurement equipment as well as the solar cell to be tested are maintained at 25 °C during electrical measurement. This temperature is always measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "Pulsed Solar Load SCD" software of the IV-tester. The PSL DF IV tester uses a multi-point contact method to measure current (I) and voltage (V) to determine the cell's IV-curve. To do so, the solar cell is placed between the multi-point contact probes in such a way that the probe fingers are in contact with the bus bars of the cell. The numbers of contact probe lines are adjusted to the number of bus bars on the cell surface. All electrical values are determined directly from this curve automatically by the implemented software package. As a reference standard, a calibrated solar cell from Berger Lichtechnik consisting of the same area dimensions, same wafer material and processed using the same front side layout is tested and the data compared to the certificated values. At least five wafers processed in the very same way are measured and the data interpreted by calculating the average of each value. The software provides values for efficiency, fill factor, short circuit current, series resistance, and open circuit voltage.

### Solar Cell Module

A contribution to achieving at least one of the above mentioned objects is made by a module having at least one solar cell obtained as described above. A plurality of solar cells according to the invention can be arranged spatially and electrically connected to form a collective arrangement called a module. Preferred modules according to the invention can have a number of arrangements, preferably a rectangular arrangement known as a solar panel. A large variety of ways to electrically connect solar cells, as well as a large variety of ways to mechanically arrange and fix such cells to form collective arrangements, are well known in the art. Preferred methods according to the invention are those which result in a low mass to power output ratio, low volume to power output ration, and high durability. Aluminum is the preferred material for mechanical fixing of solar cells according to the invention.

The invention will now be described in conjunction with the following, non-limiting examples.

### EXAMPLES

### Example 1

A first exemplary glass composition ("Glass A") was prepared, as set forth in Table 1. Weighed amounts of raw materials were mixed in a pestle and mortar. The mixture was then transferred in an alumina crucible and melted at about 900 - 1200°C in an electric furnace, model KLS 45/11 from Themconcept, Dr. Fischer GmbH & Co. KG, Bremen (Germany). The melt was poured in water to form glass frits. These glass frits were transferred into a Sintered Aluminum Oxide Grinding Jar containing YTZ® GRINDING MEDIA (ball type) with median size of 0.8 mm. Dry or wet milling to the desired glass particle size was carried out by spinning this Sintered Aluminum Oxide Grinding Jar containing the milling mixture in a planetary ball mill, PM 400 from Retsch, Germany. The rotation speed was about 30 - 300 min⁻¹.

**Table 1. Composition of Exemplary Glass A**

| **Component** | **Amount (in wt% of glass)** |
|---|---|
| **PbO** | 78.83 |
| **SiO₂** | 9.20 |
| **Al₂O₃** | 4.20 |
| **ZnO** | 0.96 |
| **Ag₂O** | 6.82 |

Glass A was then mixed with the components set forth in Table 2 to form an exemplary paste composition (Paste A). The components were placed in a plastic vial and premixed for five minutes in a High Energy Shaker-Mill model 8000M MIXER/MILL from SPEX® SamplePrep®, USA. This mixture was then milled in a three-roll mill (e.g., Model No. 80E/0393 from EXAKT Advanced Technologies GmbH, Germany). The gap between the rollers was maintained at 5 µm to 25 µm and the speed was varied from 20 rpm to 300 rpm. Each sample was passed at least 4 times through the mill in order to provide a homogeneous paste.

**Table 2. Composition of Exemplary Paste A**

| **Component** | **Amount (in wt% of paste)** |
|---|---|
| **Glass A** | 1.8 |
| **Silver** | 88 |
| **Organic Vehicle** | 9.1 |
| **TeO₂ Additive** | 0.7 |
| **ZnO Additive** | 0.2 |
| **Li₂O Additive** | 0.1 |
| **P₂O₅ Additive** | 0.1 |

Paste A and a control paste (not including the silver-containing component) were screen printed onto the front side of a lightly-doped p-type silicon wafer with a sheet resistance of 85 Ω/□, at a speed of 150 mm/s, using a 325 (mesh) * 0.9 (mil, wire diameter) * 0.6 (mil, emulsion thickness) * 55 µm (finger line opening) calendar screen. An aluminum back side paste was also applied to the back side of the silicon wafer. The printed wafer was dried at 150°C and then fired at a profile with the peak temperature at about 750-900°C for a few seconds in a linear multi-zone infrared furnace.

The resulting solar cells were then tested according to the parameters set forth herein, and various electrical performance properties were determined, including solar cell efficiency (NCell, %), fill factor (FF, %), series resistance (Rs, Ω) and short circuit current (Isc, mA/cm²). Generally, the smaller the series resistance Rs, the better contact behavior for the electroconductive pastes. The performance data was normalized to 1 with respect to the control paste, as set forth in Table 3 below.

**Table 3. Performance of Exemplary Paste A**

| **Performance** | **Control** | **Paste A** |
|---|---|---|
| **NCell (%)** | 1.00 | 0.919 |
| **FF (%)** | 1.00 | 0.928 |
| **Voc (V)** | 1.00 | 0.998 |
| **Rs (Ω)** | 1.00 | 2.247 |

### Example 2

A second exemplary glass composition ("Glass B") was prepared according to the preparation method of Example 1. The Glass B composition is set forth in Table 4. The composition of Glass B was adjusted compared to Glass A in order to determine the effect of increasing the amount of Ag₂O in the glass.

**Table 4. Composition of Exemplary Glass B**

| **Component** | **Amount (in wt% of glass)** |
|---|---|
| **PbO** | 75.04 |
| **SiO₂** | 7.07 |
| **Al₂O₃** | 4.00 |
| **ZnO** | 0.91 |
| **Ag₂O** | 12.98 |

Glass B was then mixed with the components set forth in Table 5 to form an exemplary paste composition (Paste B) according to the preparation method of Example 1.

**Table 5. Composition of Exemplary Paste B**

| **Component** | **Amount (in wt% of paste**) |
|---|---|
| **Glass B** | 1.8 |
| **Silver** | 88 |
| **Organic Vehicle** | 9.1 |
| **TeO₂ Additive** | 0.7 |
| **ZnO Additive** | 0.2 |
| **Li₂O Additive** | 0.1 |
| **P₂O₅ Additive** | 0.1 |

Paste B and the control paste from Example 1 were screen printed onto the front side of a lightly-doped p-type silicon wafer, dried and fired as described in Example 1. The resulting solar cells were then tested by the procedures provided in Example 1 and set forth fully herein. Normalized electrical performance for Exemplary Paste B, as compared to the control paste, is compiled in Table 6.

**Table 6. Electric Performance of Exemplary Paste B**

| **Performance** | **Control** | **Paste B** |
|---|---|---|
| **NCell (%)** | 1.00 | 1.007 |
| **FF (%)** | 1.00 | 1.001 |
| **Voc (V)** | 1.00 | 1.002 |
| **Rs (Ω)** | 1.00 | 1.012 |

As it can be seen, Paste B exhibited improvements in efficiency, fill factor, and open circuit voltage, as compared to the Control Paste.

These and other advantages of the invention will be apparent to those skilled in the art from the foregoing specification. Accordingly, it will be recognized by those skilled in the art that changes or modifications may be made to the above described embodiments without departing from the broad inventive concepts of the invention. Specific dimensions of any particular embodiment are described for illustration purposes only. It should therefore be understood that this invention is not limited to the particular embodiments described herein, but is intended to include all changes and modifications that are within the scope and spirit of the invention.

## Claims

1. An electroconductive paste composition comprising:
metallic particles;
glass frit comprising,
a) lead oxide,
b) silicon dioxide, and
c) silver or a silver-containing compound,
an organic vehicle.

2. The electroconductive paste according to claim 1, wherein
the paste composition comprises about 50-99 wt% metallic particles, preferably about 60-99 wt% metallic particles, more preferably about 70-99 wt% metallic particles, based upon 100% total weight of the paste.

3. The electroconductive paste according to claims 1 or 2, wherein
the paste composition comprises about 0.1-20 wt% glass frit, preferably about 0.2-12 wt% glass frit, more preferably about 0.3-8, and most preferably about 0.5-5 wt% glass frit, based upon 100% total weight of the paste.

4. The electroconductive paste according to any of the preceding claims, wherein
the paste composition comprises about 1-20 wt% organic vehicle, preferably about 1-15 wt% organic vehicle, more preferably about 5-15 wt% organic vehicle, based upon 100% total weight of the paste.

5. The electroconductive paste according to any of the preceding claims, wherein
the metallic particles are selected from the group consisting of silver, copper, gold, aluminum, nickel, and any mixtures or alloys thereof, preferably silver.

6. The electroconductive paste according to any of the preceding claims, wherein the metallic particles are spherical, flake shaped, rod shaped, or a combination of at least two thereof.

7. The electroconductive paste according to any of the preceding claims, wherein the metallic particles have a particle size d₅₀ of about 0.1 to about 10 µm.

8. The electroconductive paste according to any of the preceding claims, wherein the metallic particles have a specific surface area of about 0.1 to about 5 m²/g.

9. The electroconductive paste according to any of the preceding claims, wherein
the glass frit comprises about 0.1-30 wt% silver or a silver-containing compound, preferably about 0.1-20 wt% silver or a silver-containing compound, more preferably about 5-10 wt% silver or a silver-containing compound, based upon 100% total weight of the glass frit.

10. The electroconductive paste according to any of the preceding claims, wherein
the glass frit comprises about 10-99 wt% lead oxide, preferably about 70-99 wt%, more preferably about 70-90 wt%, and most preferably 75-85 wt% lead oxide, based upon 100% total weight of the glass frit.

11. The electroconductive paste according to any of the preceding claims, wherein
the glass frit comprises about 0.1-15 wt% silicon dioxide, preferably about 5-15 wt% silicon dioxide, and more preferably about 5-10 wt% silicon dioxide, based upon 100% total weight of the glass frit.

12. The electroconductive paste according to any of the preceding claims, wherein the silver-containing compound is silver oxide (Ag₂O).

13. The electroconductive paste according to any of the preceding claims, wherein the glass frit further comprises tellurium dioxide.

14. The electroconductive paste according to claim 13, wherein the glass frit comprises about 0.1-25 mol% tellurium dioxide.

15. The electroconductive paste according to any of the preceding claims, wherein the glass frit further comprises aluminum oxide.

16. The electroconductive paste according to any of the preceding claims, wherein the glass frit further comprises zinc oxide.

17. The electroconductive paste according to any of the preceding claims, wherein the glass frit comprises
a) about 0.1 to about 30 mol%, more preferably about 1 to about 10 mol%, of silver or a silver-containing compound, based upon 100% total moles of the glass frit;
b) about 40 to about 75 mol%, preferably about 60 to about 75 mol%, PbO, based upon 100% total moles of the glass frit;
c) about 20 to about 30 mol% SiO₂, based upon 100% total moles of the glass frit;
d) about 1 to about 10 mol%, preferably about 2 to about 5 mol%, Al₂O₃, based upon 100% total moles of the glass frit; and
e) about 1 to about 10 mol%, preferably about 2 to about 5 mol%, ZnO, based upon 100% total moles of the glass frit.

18. The electroconductive paste according to any of the preceding claims, wherein the organic vehicle comprises a binder, a surfactant, an organic solvent, and a thixotropic agent.

19. A solar cell produced by applying an electroconductive paste according to any of claims 1 - 18 to a silicon wafer and firing the silicon wafer.

20. A solar cell module comprising electrically interconnected solar cells according to claim 19.

21. A method of producing a solar cell, comprising the steps of:
providing a silicon wafer having a front side and a backside;
applying an electroconductive paste according to any of claims 1-18 to the silicon wafer; and
firing the silicon wafer.

22. The method of producing a solar cell according to claim 21, wherein the electroconductive paste is applied to the front side of the silicon wafer.
